# FASCICULE DE BREVET EUROPEEN

(11) **EP 2 019 811 B1**
(45) Date de publication et mention de la délivrance du brevet: **29.08.2018**
(21) Numéro de dépôt: 07729329.8
(22) Date de dépôt: 21.05.2007
(51) Int. Cl.: B81B 3/00

(54) **MICROCOMPOSANT MUNI D'UNE CAVITE DELIMITEE PAR UN CAPOT A RESISTANCE MECANIQUE AMELIOREE**
MIT EINEM DURCH EINE KAPPE MIT VERBESSERTER MECHANISCHER FESTIGKEIT BEGRENZTEN HOHLRAUM VERSEHENE MIKROKOMPONENTE
MICRO COMPONENT PROVIDED WITH A CAVITY BOUNDED BY A CAP WITH IMPROVED MECHANICAL STRENGTH

(30) Priorité: 22.05.2006 FR 0651876
(43) Date de publication de la demande: 04.02.2009
(73) Titulaire: Commissariat à l'Énergie Atomique et aux Énergies Alternatives, 75015 Paris (FR)
(72) Inventeur: GILLOT, Charlotte, 38000 Grenoble (FR); PORNIN, Jean-Louis, 38920 Crolles (FR); LAGOUTTE, Emmanuelle, 38160 St Marcellin (FR); JACQUET, Fabrice, 38220 Saint Pierre de Mesage (FR); HENTZ, Sébastien, 38000 Grenoble (FR)
(74) Mandataire: Ilgart, Jean-Christophe
(86) Numéro de dépôt international: PCT/EP2007/054885
(87) Numéro de publication internationale: WO 2007/135128

(56) Documents cités:
- EP-A- 1 640 329

## Description

### DOMAINE TECHNIQUE

La présente invention concerne un microcomposant muni d'une cavité délimitée par un capot à résistance mécanique améliorée.

La mise en boîtier des microsystèmes électromécaniques connus sous la dénomination de MEMS est aujourd'hui une clef de leur développement. D'autres microcomposants électroniques, optiques, optoélectroniques peuvent aussi être concernés par cette mise en boîtier. Par la suite on a employé le terme microcomposant qui englobe ici un microsystème, un composant électronique, optique ou optoélectronique.

On rend généralement la cavité hermétique au gaz et à l'humidité de manière à limiter leur vieillissement. On évite également que la poussière ne vienne perturber leur fonctionnement, notamment s'il y a des parties mobiles. Il peut aussi être souhaitable de contrôler l'atmosphère à l'intérieur de la cavité par exemple en y introduisant un gaz neutre qui évitera toute réaction chimique avec le microcomposant ou en faisant le vide. En effet l'oxygène de l'air ambiant peut dégrader leurs contacts. Le capot permet également de protéger mécaniquement le microcomposant lors d'étapes ultérieures qu'il doit subir avant son achèvement telles que la découpe, le surmoulage ou au cours de son utilisation.

Le capot peut être reporté et scellé ou être réalisé par des technologies de couches minces.

### ÉTAT DE LA TECHNIQUE ANTÉRIEURE

La technique de fabrication des capots en couche mince de tels microcomposants est bien connue pour délimiter une cavité à atmosphère contrôlée au dessus de la partie active du microcomposant. On peut notamment trouver des explications à ce sujet dans les demandes de brevet européen EP-A-0 525 764 et EP-A-1 101 730.

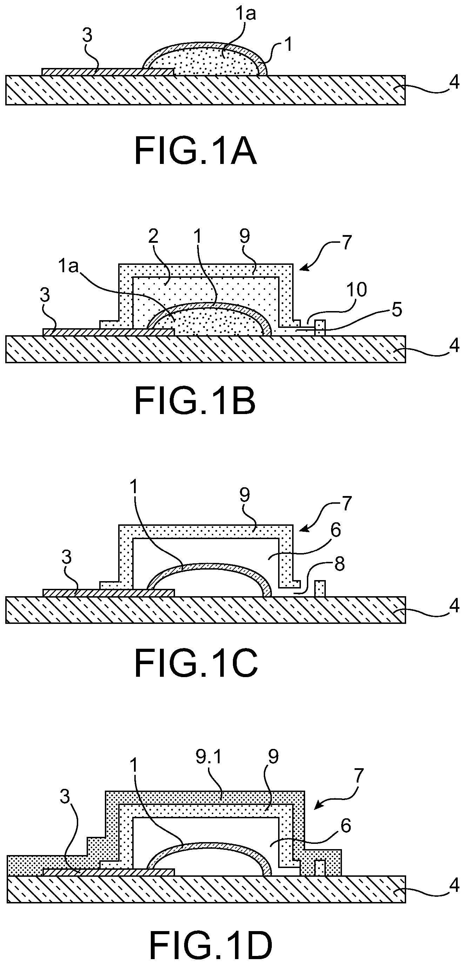

On va décrire de manière succincte un procédé de réalisation connu d'un capot en couche mince destiné à la protection d'une partie active 1 d'un microcomposant disposée sur un substrat 4. On peut se référer aux figures 1A à 1D. On dépose sur la partie active 1 une couche d'un matériau sacrificiel 2 que l'on va mettre en forme et délimiter pour lui donner une forme adaptée à celle d'une cavité 6 qui enfermera la partie active 1 du microcomposant. La cavité 6 sera délimitée par le capot 7 à venir, cette forme correspond à celle de l'intérieur du capot 7. Dans l'exemple décrit, le microcomposant est un composant électromécanique MEMS et sa partie active est une poutre 1 qui est destinée à se courber en fonctionnement. A ce stade, la poutre 1 n'est pas totalement achevée, elle n'a pas été libérée et repose sur une couche sacrificielle la qui est disposée sur le substrat 4. La figure 1A illustre la partie active 1 avant le dépôt de la couche sacrificielle 2 et la figure 1B après.

La couche sacrificielle 2 destinée à donner la forme intérieure du capot 7 s'appuie sur un conducteur 3 de commande du déplacement de la poutre 1. Elle comporte, à un endroit décalé de la poutre 1 au niveau du substrat 4 une partie d'épaisseur moindre 5. Cette partie 5 correspondra à l'intérieur d'un canal de libération 8 qui sera créé ultérieurement et qui servira à évacuer le matériau sacrificiel se trouvant autour de la poutre 1 et occupant le volume de la cavité 6 délimitée par le capot 7.

On dépose ensuite sur la couche sacrificielle 2 une couche de capot 9 qui réalise les parois du capot 7. Cette étape est illustrée à la figure 1B. Au niveau de la partie d'épaisseur moindre 5, la couche de capot 9 forme le canal 8 de libération. On prévoit de graver au moins un orifice d'évacuation 10 dans la couche de capot 9. On élimine le matériau sacrificiel en l'évacuant par l'orifice 10. Ceci est visible à la figure 1C. On dépose sur l'ensemble obtenu à la figure 1C, une couche de bouchage 9.1 qui recouvre le capot 7 et bouche le trou d'évacuation 10. On peut se référer à la figure 1D.

D'un point de vue mécanique un tel capot 7 doit pouvoir résister à des différences de pression entre son intérieur et l'extérieur en se déformant le moins possible. Si la déflexion du capot 7 est trop importante, il risque de venir en contact avec la partie active 1, de gêner son évolution ou même pire de la détériorer. La différence de pression entre l'intérieur et l'extérieur de capot 7 peut être liée au milieu qu'il emprisonne. Il peut s'agir du vide ou d'une pression différente de la pression environnante. Cette pression environnante peut être différente de la pression atmosphérique selon l'application envisagée. Il faut noter que pour achever le microcomposant, après avoir réalisé le capot 7, on peut être amené à l'enrober de matière plastique ou à le surmouler et que ces étapes s'effectuent à des pressions élevées pouvant atteindre 10⁷ Pascals.

L'épaisseur des capots effectués en couche mince est typiquement comprise dans une plage allant de quelques micromètres à quelques dizaines de micromètres. Leur déformation sous l'effet de pression peut être tout à fait significative. Pour augmenter la résistance mécanique du capot, il a été proposé de choisir un matériau pour le capot qui présente une bonne rigidité et d'ajuster avec soin son épaisseur. Dans la demande de brevet américain 2004/0173886 il est préconisé de réaliser un capot multicouche incluant de l'alumine. Cependant, des matériaux rigides qui conviennent pour leurs propriétés mécaniques ne sont pas forcément couramment utilisés en microélectronique et dans les microsystèmes et leur introduction peut être difficile à mettre en oeuvre, ils peuvent poser des problèmes de contamination ou nécessiter des développements spécifiques.

On a aussi proposé de placer des piliers dans la cavité délimitée par le capot pour supporter la paroi du capot. On peut se référer au document « Polisilicon vibrating gyroscope vacuum-encapsulated in an on-chip micro-chamber » Toshiyuki Tsuchiya et al., Sensors ans Actuators A90, 2001, pages 49 à 55. Dans cette configuration, le capot repose sur un grand nombre de petits piliers qui limitent son fléchissement. L'encombrement supplémentaire lié à la présence des piliers est un inconvénient non négligeable. De plus, la conception du microsystème est limitée car il faut tenir compte de la position des piliers. En outre dans certains cas, il n'est pas possible d'ancrer les piliers sur le substrat qui forme la base de la cavité.

EP 1 640 329 divulgue différents modes de réalisation d'un microcomposant muni d'un capot comportant une paroi sommitale. Cette paroi sommitale comporte des moyens de rigidification avec des éléments de rigidification en saillie.

### EXPOSÉ DE L'INVENTION

La présente invention a justement comme but de proposer un microcomposant muni d'une cavité délimitée par un capot dont la résistance mécanique est améliorée et qui ne présente pas les inconvénients de mentionnés ci-dessus, en particulier qui ne présente pas les contraintes engendrées par les piliers à l'intérieur de la cavité et qui soit aisément fabricable par des techniques classiques de dépôt en couches minces.

Pour atteindre ces buts l'invention concerne plus précisément un microcomposant comportant une cavité délimitée par un capot enfermant une partie active supportée par un substrat. Le capot comprend une paroi sommitale comportant des moyens de rigidification avec au moins un élément de rigidification en saillie, cet élément de rigidification en saillie étant situé entre deux zones en retrait de la paroi sommitale et ayant une extrémité éloignée des zones en retrait sans contact avec le substrat.

La paroi sommitale est bombée, et la saillie de l'élément de rigidification provient de la courbure de la paroi sommitale, l'épaisseur de la paroi sommitale étant constante au niveau de l'élément de rigidification.

L'élément de rigidification en saillie peut prendre avantageusement la forme d'une moulure ou d'un pavé.

La moulure ou le pavé peut avoir une section transversale rectangulaire, trapézoïdale ou arrondie.

La paroi sommitale peut être dotée de plusieurs moulures sensiblement parallèles qui suivent un bord de la paroi.

En variante, la paroi sommitale peut être dotée de deux moulures agencées en croix.

Selon un autre mode de réalisation, la paroi sommitale peut être dotée de plusieurs moulures ramifiées en nid d'abeille.

Selon encore un autre mode de réalisation, la paroi sommitale peut être dotée d'une pluralité de pavés agencés en matrice.

L'élément de rigidification en saillie est dirigé soit vers l'intérieur, soit vers l'extérieur de la cavité.

L'extrémité de élément de rigidification en saillie peut être libre.

Dans un mode de réalisation particulièrement avantageux mécaniquement, le capot peut comporter une paroi de doublage qui double la paroi sommitale, l'extrémité de l'élément de rigidification en saillie étant en contact avec la paroi de doublage.

On prévoit dans la paroi sommitale et dans la paroi de doublage, si elle est présente, au moins un orifice, l'orifice de la paroi sommitale et l'orifice de la paroi de doublage communiquant l'un avec l'autre.

L'orifice de la paroi, la plus externe du capot, parmi la paroi sommitale et la paroi de doublage, est flanqué d'un bouchon.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A à 1D montrent des étapes de réalisation d'un microcomposant muni d'une cavité délimitée par un capot de l'art antérieur ;
les figures 2A, 2B, 2C et 2F sont des exemples, en coupe, d'un microcomposant muni d'une cavité délimitée par un capot, utiles pour comprendre l'invention ;
les figures 2D et 2E sont des exemples, en coupe, d'un microcomposant muni d'une cavité délimitée par un capot selon l'invention ;
les figures 3A à 3G montrent un exemple d'étapes de réalisation d'un microcomposant muni d'une cavité délimitée par un capot selon l'invention ;
les figures 4A à 4F montrent un autre exemple d'étapes de réalisation d'un microcomposant muni d'une cavité délimitée par un capot, utiles pour comprendre l'invention ;
les figures 5A à 5D montrent divers exemples de motifs en creux utilisés pour réaliser les moyens de rigidification du capot du microcomposant de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

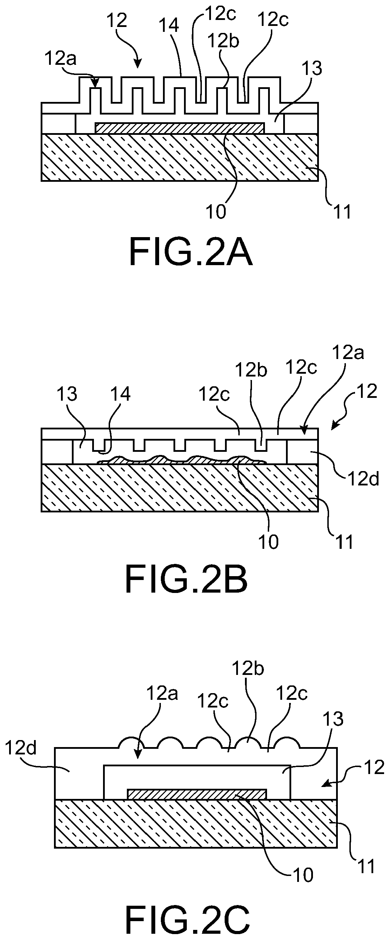

On va maintenant se référer aux figures 2A à 2F qui montrent des exemples de microcomposant.

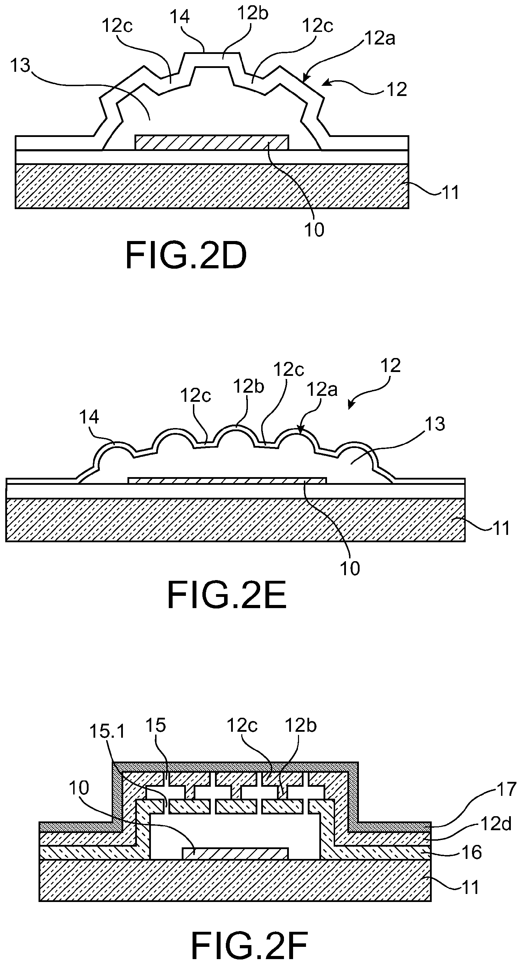

Le microcomposantcomporte une partie active 10, par exemple un actionneur, un résonateur ou tout autre composant électronique, optique, optoélectronique ou électromécanique, supportée par un substrat 11. Un capot 12 recouvre la partie active 10 et délimite une cavité 13 dans laquelle est enfermée la partie active 10. Le capot 12 prend appui sur le substrat 11. Il comporte une paroi sommitale 12a qui s'étend au niveau d'une partie sommitale de la cavité 13 et qui est sensiblement en vis-à-vis de la partie active 10. La paroi sommitale 12a comporte des moyens de rigidification formés d'au moins un élément de rigidification 12b en saillie. Cet élément de rigidification en saillie 12b est situé entre deux zones en retrait 12c de la paroi sommitale 12a. L'élément de rigidification en saillie 12b a une extrémité 14 qui dépasse par rapport aux zones en retrait 12c et cette extrémité 14 est située au-delà de la partie active 10 par rapport au substrat 11. Cette extrémité 14 est éloignée des zones en retrait 12c. Si la partie active 10 est susceptible de se déplacer, ni l'élément de rigidification en saillie 12b, ni les zones en retrait 12c ne viennent entraver la partie active 10 lors de ses mouvements. De plus, son extrémité 14 n'est pas en contact non plus avec le substrat 11. L'élément de rigidification en saillie 12b ne peut être assimilé à un pilier. L'extrémité 14 qui dépasse peut être libre comme sur les figures 2A à 2E. L'élément de rigidification en saillie 12b peut se projeter vers l'intérieur de la cavité 13 comme sur les figures 2B, 2F ou au contraire vers l'extérieur de la cavité 13 comme sur les figures 2A, 2C. La paroi sommitale 12a peut être plane comme sur les figures 2A, 2B, 2C, 2F ou bombée comme sur les figures 2D, 2E.

L'élément de rigidification en saillie 12b peut prendre la forme d'une moulure ou d'un pavé. Lorsqu'il y a plusieurs pavés, ils peuvent être agencés en lignes et colonnes. Lorsqu'il y a plusieurs moulures, elles peuvent être sensiblement parallèles ou se croiser.

Ces éléments de rigidification en saillie 12b peuvent être matérialisés par un épaississement de la paroi sommitale 12a comme sur les figures 2B, 2C, 2F ou par une courbure de cette paroi sommitale 12a, dans ce cas, l'épaisseur de la paroi sommitale 12a est sensiblement constante au niveau des éléments de rigidification en saillie 12b. Cette dernière configuration est illustrée sur les figures 2A, 2D, 2E. Cette courbure peut faire que les éléments de rigidification en saillie prennent par exemple sensiblement la forme de créneaux ou de créneaux renversés.

Dans certaines configurations, le capot 12 se compose de la paroi sommitale 12a et d'une paroi latérale 12d qui entoure la partie active 10 et qui repose sur le substrat 11 comme sur les figures 2A, 2B, 2C, 2F. Au contraire, il est possible que la paroi sommitale 12a se prolonge jusqu'à ce que son bord repose sur le substrat 11.

L'élément de rigidification en saillie 12b peut avoir une section pleine ou creuse selon que la paroi sommitale 12a a été épaissie ou seulement courbée. La section de l'élément de rigidification en saillie 12b, que ce soit une moulure ou un pavé, peut être rectangulaire, trapézoïdale, arrondie, en U ou autre.

On peut prévoir un ou plusieurs orifices 15 dans le capot 12 comme illustré sur la figure 2F. On verra ultérieurement leur fonction.

On peut envisager, comme illustré sur la figure 2F, qu'une paroi de doublage 16 double la paroi sommitale 12a pourvue des moyens de rigidification. Dans cette configuration, l'élément de rigidification en saillie 12b se projette vers la paroi de doublage 16. Cette paroi de doublage se trouve à l'intérieur de la cavité 13, mais on aurait très bien pu envisager qu'elle se trouve à l'extérieur de la cavité 13. L'extrémité 14 de l'élément de rigidification en saillie 12b vienne en contact avec la paroi de doublage 16.

Les exemples des figures 2 n'illustrent que quelques formes pour les éléments de rigidification en saillie, d'autres sont envisageables. Ces exemples ne sont en aucun cas limitatifs. D'ailleurs par la suite, on verra d'autres formes possibles.

Les parois 12a, 16 que l'on vient de décrire peuvent être monocouches ou multicouches.

La paroi sommitale 12a et/ou la paroi de doublage 16 peuvent être réalisées par exemple en dioxyde de silicium SiO₂ ou en nitrure de silicium SiN ou en métal tel que le nickel, le cuivre, l'or ou même en polysilicium ou en une combinaison de ces matériaux.

Lors de sa fabrication, le capot 12 et plus particulièrement sa paroi sommitale 12a comporte au moins un orifice 15 qui sert à l'évacuation du matériau sacrificiel qui a été utilisé pour délimiter la forme de la cavité 13. Cet orifice 15 doit être bouché, et le bouchage peut être réalisé par une couche de bouchage 17, assimilée à un bouchon, qui s'étend sur la paroi sommitale 12a, notamment dans le cas où l'orifice 15 traverse la paroi sommitale 12a. Cette configuration n'est représentée que sur la figure 2F car c'est la seule parmi les figures 2 qui montre des orifices.

Dans cette configuration de la figure 2F, la paroi de doublage 16 comporte également au moins un orifice 15.1 qui communique avec l'orifice 15 de la paroi sommitale 12a. Sur les autres figures 2, on n'a représenté aucun orifice dans un souci de clarté, l'accent étant porté sur la paroi sommitale. Il est bien entendu que ces orifices existent et qu'ils doivent être bouchés.

La maîtrise de la forme du capot et le choix des matériaux qui le compose et de son épaisseur permet d'obtenir une résistance mécanique appropriée. En jouant sur la forme du capot et notamment sur la forme de l'élément de rigidification en saillie, il est possible d'augmenter la résistance du capot aux pressions extérieures par rapport à un capot de l'art antérieur de même épaisseur. Il est également possible d'obtenir un capot ayant une même résistance mécanique avec une épaisseur moindre.

L'épaisseur moindre de celle des capots de l'art antérieur a pour avantage d'engendrer des coûts de fabrication réduits, les durées mises en jeu pour effectuer le dépôt de la paroi du capot et leur gravure étant raccourcies. De plus, on sait que lors du dépôt de couches épaisses, il est difficile de maîtriser la contrainte de la couche formant la paroi, cette dernière peut alors se décoller du substrat ou se déformer. En utilisant une couche moins épaisse, ces inconvénients sont éliminés.

L'homme du métier peut calculer la structure des moyens de rigidification en fonction des contraintes de son application telles que la tenue à la pression souhaitée, la déflexion maximale permise pour le capot, la taille du capot, les propriétés mécaniques et l'épaisseur du matériau du capot. Il est possible d'utiliser un logiciel de calculs par éléments finis tel que le logiciel de simulation ANSYS (marque déposée de la société ANSYS). A partir d'une géométrie donnée du capot (dimensions et forme) et des propriétés physiques des matériaux utilisés, le logiciel calcule la déflexion du capot pour une contrainte en pression donnée. Il est ainsi possible de choisir la structuration du capot, c'est-à-dire le nombre, la position et les dimensions (hauteur, longueur, largeur) des éléments de rigidification en saillie.

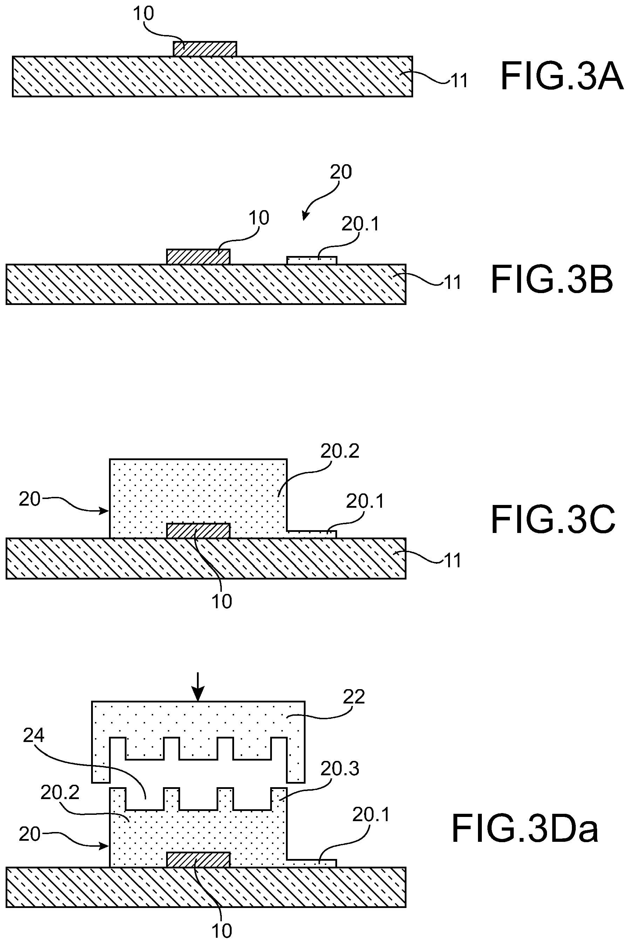

On va maintenant s'intéresser à un procédé de fabrication de la cavité 13 dans laquelle est enfermée la partie active 10 du microcomposant et par conséquent un procédé de fabrication du capot qui la délimite. On part d'un substrat 11 sur lequel repose la partie active 10 comme illustré sur la figure 3A. On ne décrit pas plus en détail comment a été obtenu cette partie active 10 car une grande variété de parties actives conviennent.

On dépose sur le substrat 11 du matériau sacrificiel 20, en au moins une couche, de manière à ce qu'il recouvre la partie active 10 et le substrat 11. Ce matériau sacrificiel 20 va servir à délimiter le volume de la cavité qui va être créée en servant de forme pour le capot.

Ce matériau sacrificiel 20 peut être déposé en une première couche 20.1 dite canal qui s'étend un peu au-delà de l'emprise qu'aura la cavité sur le substrat 11, si on décide de placer l'orifice dans une zone périphérique de la cavité et qu'il faut réaliser un canal d'évacuation. Cette couche sacrificielle canal 20.1 est de faible épaisseur, de l'ordre de quelques dixièmes de micromètres voire du micromètre. Typiquement, elle peut être comprise entre 0,2 à 1 micromètre. Le matériau sacrificiel de la couche de canal peut être un polymère tel qu'une résine photosensible, par exemple celle de JSR Corporation de référence JSR PFR420. Cette couche de canal 20.1 est délimitée par photolithographie au contour de l'emprise de la cavité et du canal d'évacuation. On peut se référer à la figure 3B. Cette étape est inutile si l'orifice d'évacuation ne se trouve pas à la base de la cavité. On réalisera alors directement une couche sacrificielle principale en surface du substrat 11. L'emprise de la cavité à la surface du substrat 11 peut être de l'ordre de quelques dizaines à quelques centaines de micromètres de côté. On peut également utiliser comme matériau sacrificiel du dioxyde de silicium SiO₂. Dans ce cas la mise en forme se fait par gravure sèche par exemple sous CHF₃ O₂ ou par gravure humide avec par exemple une solution d'attaque d'oxyde enterré (en anglais buried oxide etch solution) à travers un masque.

On dépose ensuite une couche sacrificielle principale 20.2 qui va servir, au moins, à délimiter latéralement la cavité, c'est-à-dire à délimiter au moins partiellement la cavité. Cette couche sacrificielle principale 20.2 peut être mise en forme par photolithographie par exemple au contour latéral de l'intérieur de la cavité. On peut se référer à la figure 3C. La partie active 10 est noyée dans la couche sacrificielle principale 20.2. Cette couche sacrificielle principale 20.2 a une épaisseur de quelques micromètres voire d'une dizaine de micromètres au dessus de la partie active 10 du microcomposant à protéger. Typiquement cette épaisseur peut être comprise entre 4 et 10 micromètres. Cette couche sacrificielle principale 20.2 peut être réalisée dans le même matériau que la couche sacrificielle de canal 20.1 mais ce n'est pas une obligation comme on le verra ultérieurement.

On suppose à l'étape illustrée à la figure 3Da que l'on va réaliser dans le matériau sacrificiel 20 un motif en creux 24 correspondant à l'inverse de celui de l'élément de rigdification en saillie des moyens de rigidification. Dans l'exemple décrit sur la figure 3Da, ce motif 24 va être réalisé par emboutissage en utilisant un outil 22 ayant un motif en relief qui correspond à celui des moyens de rigidification. On presse cet outil 22 en surface de la couche sacrificielle principale 20.2 et le matériau sacrificiel 20 se déforme par fluage. On obtient alors, au sommet de la couche sacrificielle principale 20.2, en creux, le motif 24 des moyens de rigidification. Dans ce cas, il n'est pas nécessaire que le matériau sacrificiel de la couche sacrificielle principale 20.2 soit photosensible, il peut s'agir de polyimide si l'outil 22 prend la forme d'un moule dont le bord contribue à délimiter latéralement la cavité.

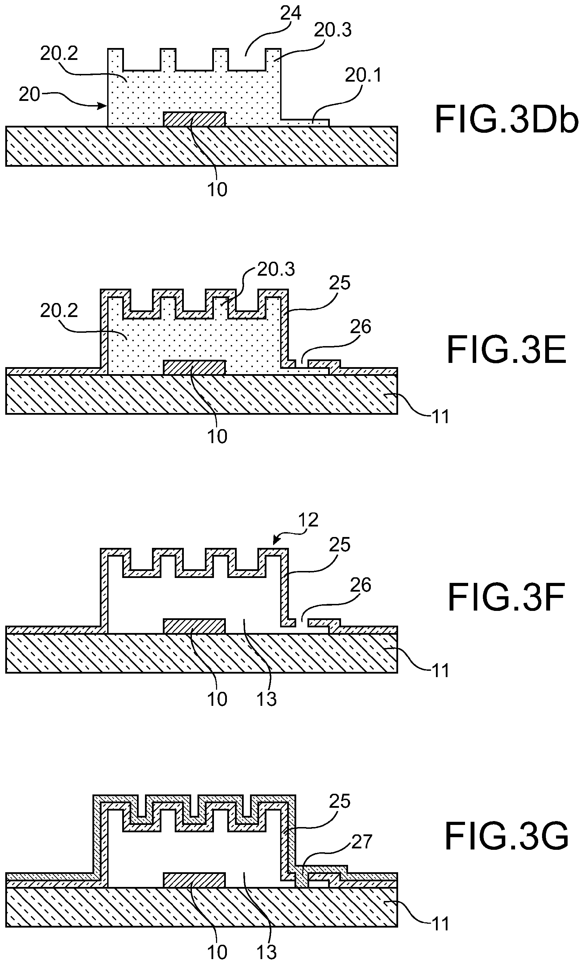

Il est possible d'utiliser une couche sacrificielle supplémentaire dite de structuration 20.3 qui ne sert que pour réaliser les moyens de rigidification. On dépose cette couche sacrificielle de structuration 20.3 sur la couche sacrificielle principale 20.2. Cette couche est délimitée et gravée par exemple par photolithographie au motif en creux 24 inverse de celui des moyens de rigidification. Cette variante est illustrée sur la figure 3Db. La couche sacrificielle de structuration 20.3 peut être réalisée en polymère, dans le même matériau que la couche sacrificielle principale 20.2 ou dans un matériau différent. Elle doit pouvoir être mise en forme et gravée sans dégrader l'élément actif 10 et doit être compatible avec le matériau du capot à venir. Cette remarque s'applique d'ailleurs à toutes les couches sacrificielles. L'épaisseur de la couche sacrificielle de structuration 20.3 est comprise entre environ 1 et 10 micromètres par exemple. La largeur des éléments de rigidification en saillie et donc des motifs en creux est également comprise entre environ 1 et 10 micromètres par exemple.

On va ensuite déposer au moins une couche de capot 25 pour réaliser le capot et notamment sa paroi sommitale. Cette couche 25 recouvre la couche sacrificielle de structuration 20.3, s'étend latéralement à la couche sacrificielle principale 20.2 et recouvre également la couche sacrificielle de canal 20.1 si elle est présente. Le dépôt est un dépôt conforme. Il peut s'agir de dioxyde de silicium SiO₂, de nitrure de silicium SiN, de silicium polycristallin ou de métal tel que le nickel, le cuivre, l'or ou s'il y a plusieurs couches d'un empilement SiN/SiO₂ par exemple. Le type de dépôt dépend du matériau déposé. Il peut s'agir pour les métaux d'un dépôt par électrolyse. Pour le dioxyde de silicium SiO₂, le nitrure de silicium SiN, le silicium polycristallin, il peut s'agir par exemple d'un dépôt chimique en phase vapeur activé par plasma (en anglais Plasma Enhanced Chemical Vapor Déposition, connu avec l'abréviation PECVD) ou d'un dépôt chimique en phase vapeur à basse pression (en anglais Low Pressure Chemical Vapor Déposition, connu avec l'abréviation LPCVD).

L'épaisseur de la couche de capot 25 peut être comprise entre environ 1 et 3 micromètres par exemple ou même aller jusqu'à quelques dizaines de micromètres pour les métaux déposés par électrolyse.

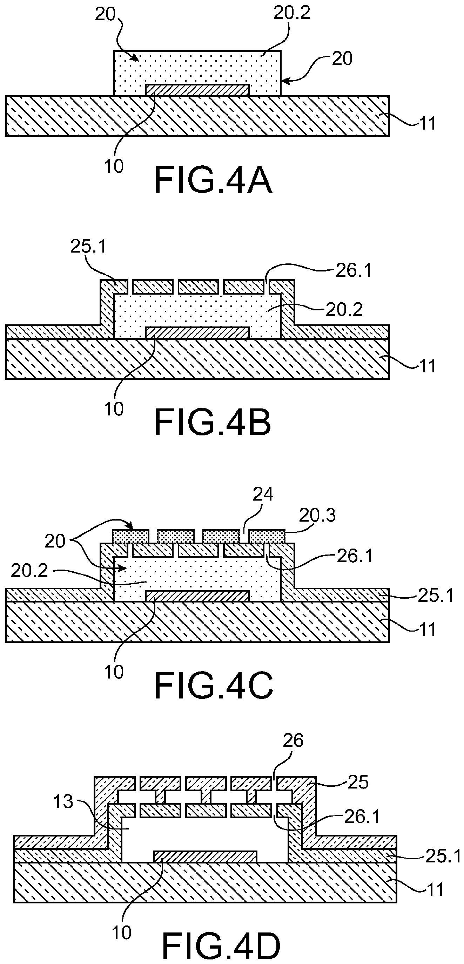

On va graver dans cette couche de capot 25 au moins un orifice d'évacuation 26 du matériau sacrificiel de manière à vider la cavité. Dans l'exemple de la figure 3E, cet orifice d'évacuation 26 se trouve à l'endroit où la couche de canal 20.1 n'est pas recouverte de la couche sacrificielle principale 20.2, à la périphérie de la cavité. Dans une autre configuration comme celle de la figure 4D, cet orifice d'évacuation se trouve au niveau de la paroi sommitale.

On va ensuite éliminer le matériau sacrificiel 20 en l'évacuant par l'ouverture 26 de manière à vider la cavité. Cette évacuation peut se faire par exposition à un plasma d'oxygène qui élimine les résidus organiques, dans la mesure où le matériau sacrificiel est un polymère. Si le matériau sacrificiel est du dioxyde de silicium, il pourra être dissous à l'aide d'une solution à base d'acide fluorhydrique HF. On peut se référer à la figure 3F qui montre la cavité 13 libérée.

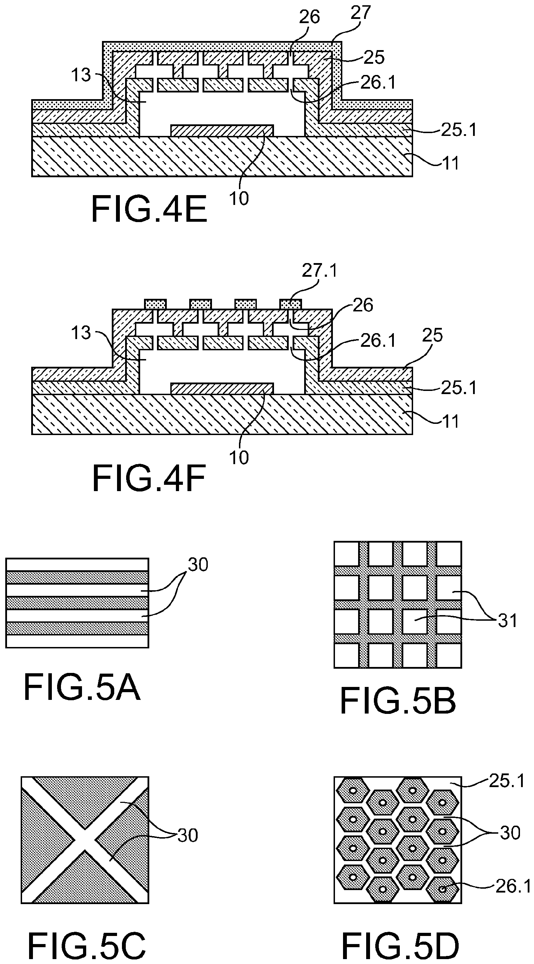

On va ensuite boucher l'orifice 26 comme illustré à la figure 3G. Ce bouchage peut rendre la cavité 13 hermétique. Ce bouchage peut se faire en déposant au moins une couche de bouchage 27 au dessus de la couche de capot 25. Cette couche peut être en dioxyde de silicium SiO₂, en nitrure de silicium, en polymère tel que le polyimide ou le benzocyclobutène BCB, en silicone, en métal tel que le nickel, le cuivre, l'or. S'il y a plusieurs couches, elles peuvent être choisies parmi ces matériaux. L'épaisseur de la couche de bouchage 27 peut être comprise entre environ un micromètre et cinquante micromètres. Par exemple s'il s'agit d'un multicouche de SiN /SiO₂ ou d'une couche de SiN, l'épaisseur peut être comprise entre 1 et 3 micromètres, pour le polymère on peut se placer dans une plage comprise entre environ 5 et 30 micromètres et pour la silicone, la plage peut être comprise entre environ 5 et 50 micromètres. La couche de bouchage 27 peut être gravée partout sauf au-dessus d'une région au-dessus de ou des l'orifice(s) 26 pour former au-dessus de chaque orifice 26 un bouchon localisé 27.1. Cette variante est illustrée à la figure 4F.

Les figures 4A à 4E montrent un autre exemple de réalisation de la cavité. Ce mode de réalisation conduit à la structure illustrée à la figure 2F et la paroi sommitale qui porte les moyens de rigidification est doublée par une paroi de doublage.

On suppose que dans cet exemple, on a placé au moins un orifice d'évacuation sur la paroi sommitale et donc la couche sacrificielle de canal est omise.

On réalise la couche sacrificielle principale 20.2 comme décrit précédemment. On la recouvre d'au moins une couche de doublage 25.1 qui peut être réalisée à partir des matériaux cités précédemment pour la couche de capot. On grave un ou plusieurs orifices 26.1 dans cette couche de doublage 25.1. On dépose ensuite sur la couche de doublage 25.1, la couche sacrificielle de structuration 20.3 que l'on met en forme et dans laquelle on grave le motif 24 des moyens de rigidification. Cette étape est illustrée à la figure 4C.

On dépose ensuite au moins la couche de capot 25 sur la couche sacrificielle de structuration 20.3. Cette couche de capot 25 est dotée des moyens de rigidification. Elle conduit à la paroi sommitale du capot. On grave dans la couche de capot 25 un ou plusieurs orifices 26 placés de manière que le matériau sacrificiel de la couche sacrificielle principale 20.2 puisse être évacué en passant à travers les orifices 26.1 de la couche de doublage 25.1 et à travers les orifices 26 de la couche de capot 25. On élimine le matériau sacrificiel 20 comme cela a été décrit à l'exemple précédent. On effectue le bouchage des orifices en déposant une couche de bouchage 27 au dessus de la couche de capot 25 comme illustré à la figure 4E. On peut ensuite par gravure de la couche de bouchage 27 réaliser des bouchons localisés 27.1 comme évoqué plus haut. Cette étape est illustrée à la figure 4F.

On va donner maintenant à titre d'exemples plusieurs formes pour les éléments de rigidification en saillie des moyens de rigidification en se référant aux figures 5. Ces figures illustrent en vue de dessus le motif qui est gravé dans la couche sacrificielle de structuration pour obtenir ces moyens de rigidification. Sur ces figures la couche sacrificielle de structuration est représentée grisée et les parties en blanc montrent la couche sacrificielle principale qui apparaît une fois que le motif a été gravé dans la couche sacrificielle de structuration.

Sur la figure 5A, on a gravé des rainures parallèles 30 dans la couche sacrificielle de structuration. La paroi sommitale du capot possédera des moulures parallèles qui correspondent au volume intérieur des rainures. Cette configuration convient bien pour des capots dont la paroi sommitale est rectangulaire. Ces moulures suivent le bord de la paroi sommitale.

Sur la figure 5B, on a gravé des cuves 31 de section sensiblement carré, ces cuves 31 étant agencées sensiblement régulièrement en lignes et en colonnes. On a conservé dans le matériau de la couche sacrificielle de structuration deux séries de moulures. Les moulures d'une série sont sensiblement parallèles. Les moulures d'une série et les moulures de l'autre série se croisent sensiblement à angle droit. Les éléments de rigidification seront des pavés agencés en lignes et en colonnes. Cette configuration convient particulièrement bien aux capots dont la paroi sommitale est sensiblement carrée.

Sur la figure 5C, on a gravé deux rainures 30 qui se croisent dans la couche sacrificielle de structuration et forment une croix. Ces rainures 30 sont les diagonales de la section qu'a la couche sacrificielle de structuration en vue de dessus. Les éléments de rigidificatoion seront deux moulures qui forment une croix. Cette configuration est particulièrement intéressant lorsque la paroi sommitale est bombée en forme de voûte. L'emprise du capot sur le substrat étant sensiblement carrée.

La figure 5D peut illustrer la configuration des figures 4 mais ce n'est pas une obligation. Si c'est le cas, la partie blanche illustre la couche de doublage qui est mise à nu par la gravure de la couche sacrificielle de structuration. On a gravé dans la couche sacrificielle de structuration des rainures 30 ramifiées en nid d'abeille. Les éléments de rigidification seront des moulures agencées en nid d'abeille. On également représenté les premiers orifices 26.1 qui se trouvent dans la couche de doublage.

Les différentes variantes décrites doivent être comprises comme n'étant pas exclusives les unes des autres.

Bien que plusieurs modes de réalisation de la présente invention aient été représentés et décrits de façon détaillée, on comprendra que différents changements et modifications peuvent être apportés sans sortir du cadre de l'invention.

## Revendications

1. Microcomposant comportant une cavité (13) délimitée par un capot (12) enfermant une partie active (10) supportée par un substrat (11), le capot (13) comprenant une paroi sommitale (12a) comportant des moyens de rigidification avec au moins un élément de rigidification en saillie (12b), cet élément de rigidification (12b) étant situé entre deux zones en retrait (12c) de la paroi sommitale (12a) et ayant une extrémité (14) éloignée des zones en retrait (12c) et sans contact avec le substrat (11),
**caractérisé en ce que** la paroi sommitale est bombée,
et **en ce que** la saillie de l'élément de rigidification provient de la courbure de la paroi sommitale, l'épaisseur de la paroi sommitale étant constante au niveau de l'élément de rigidification.

2. Microcomposant selon la revendication 1, **caractérisé en ce que** l'élément de rigidification en saillie (12b) est une moulure ou un pavé.

3. Microcomposant selon la revendication 2, **caractérisé en ce que** la paroi sommitale (12a) comporte plusieurs moulures sensiblement parallèles qui suivent un bord de la paroi sommitale (12a).

4. Microcomposant selon la revendication 2, **caractérisé en ce que** la paroi sommitale (12a) comporte deux moulures agencées en croix.

5. Microcomposant selon la revendication 2, **caractérisé en ce que** la paroi sommitale (12a) comporte plusieurs moulures ramifiées en nid d'abeille.

6. Microcomposant selon la revendication 2, **caractérisé en ce que** la paroi sommitale (12a) comporte une pluralité de pavés agencés en matrice.

7. Microcomposant selon l'une des revendications 1 à 6, **caractérisé en ce que** le capot (12) comporte une paroi de doublage (16) qui double la paroi sommitale (12a), l'extrémité (14) de l'élément de rigidification en saillie (12b) étant en contact avec la paroi de doublage (16).

8. Microcomposant selon l'une des revendications 1 à 7, **caractérisé en ce que** la paroi sommitale (12a) et la paroi de doublage (12c), si elle est présente, comportent au moins un orifice ((26.1, 16.2), l'orifice (26.2) de la paroi sommitale (12a) et l'orifice (26.1) de la paroi de doublage (16) communiquant l'un avec l'autre.

9. Microcomposant selon la revendication 8, **caractérisé en ce que** l'orifice (26.2) de la paroi la plus externe du capot (13), parmi la paroi sommitale (12a) et la paroi de doublage (16), est flanqué d'un bouchon.

## Patentansprüche

1. Mikrokomponente, enthaltend einen Hohlraum (13), der von einer Kappe (12) eingegrenzt wird, die ein von einem Substrat (11) getragenes Wirkteil umschließt, wobei die Kappe (13) eine obere Wand (12a) umfasst, die Versteifungsmittel mit mindestens einem vorspringenden Versteifungselement (12b) umfasst, wobei sich dieses Versteifungselement (12b) zwischen zwei zurückspringenden Bereichen (12c) der oberen Wand (12a) befindet und ein von den zurückspringenden Bereichen entfernt liegendes Ende (14) hat, das keinen Kontakt mit dem Substrat (11) hat,
**dadurch gekennzeichnet, dass** die obere Wand gekrümmt ist,
und dass der Vorsprung des Versteifungselements von der Krümmung der oberen Wand stammt, wobei die Dicke der oberen Wand in Höhe des Versteifungselements konstant ist.

2. Mikrokomponente nach Anspruch 1, **dadurch gekennzeichnet, dass** das vorspringende Versteifungselement (12b) ein Leistenteil oder ein Blockteil ist.

3. Mikrokomponente nach Anspruch 2, **dadurch gekennzeichnet, dass** die obere Wand (12a) mehrere im Wesentlichen parallel verlaufende Leistenteile enthält, die einem Rand der oberen Wand (12a) folgen.

4. Mikrokomponente nach Anspruch 2, **dadurch gekennzeichnet, dass** die obere Wand (12a) zwei kreuzförmig angeordnete Leistenteile enthält.

5. Mikrokomponente nach Anspruch 2, **dadurch gekennzeichnet, dass** die obere Wand (12a) mehrere wabenartig verzweigte Leistenteile enthält.

6. Mikrokomponente nach Anspruch 2, **dadurch gekennzeichnet, dass** die obere Wand (12a) eine Mehrzahl von matrixartig angeordneten Blockteilen enthält.

7. Mikrokomponente nach einem der Ansprüche 1 bis 6, **dadurch gekennzeichnet, dass** die Kappe (12) eine Verdoppelungswand (16) enthält, welche die obere Wand (12a) verdoppelt, wobei das Ende (14) des vorspringenden Versteifungselements (12b) in Kontakt mit der Verdoppelungswand (16) steht.

8. Mikrokomponente nach einem der Ansprüche 1 bis 7, **dadurch gekennzeichnet, dass** die obere Wand (12a) und die Verdoppelungswand (12c), sofern vorhanden, zumindest eine Öffnung (26.1, 16.2) aufweisen, wobei die Öffnung (26.2) der oberen Wand (12a) und die Öffnung (26.1) der Verdoppelungswand (16) miteinander kommunizieren.

9. Mikrokomponente nach Anspruch 8, **dadurch gekennzeichnet, dass** die Öffnung (26.2) der weiter außen liegenden Wand der Kappe (13) aus oberer Wand (12a) und Verdoppelungswand (16) von einem Stopfen übergriffen wird.

## Claims

1. Microcomponent comprising a cavity (13) delimited by a cap (12) enclosing an active part (10) supported by a substrate (11), the cap (13) comprising a top wall (12a) comprising stiffening means with at least one projecting stiffening member (12b), said stiffening member (12b) being located between two recessed areas (12c) of the top wall (12a) and having one end (14) at a distance from the recessed areas (12c) without coming into contact with the substrate (11),
**characterized in that** the top wall is convex,
and **in that** the projection of the stiffening member arises from the curvature of the top wall, the thickness of the top wall being constant on the stiffening member.

2. Microcomponent according to claim 1, **characterised in that** projecting stiffening member (12b) is a moulding or a block.

3. Microcomponent according to claim 2, **characterised in that** the top wall (12a) comprises several substantially parallel mouldings along the edge of the top wall (12a).

4. Microcomponent according to claim 2, **characterised in that** the top wall (12a) comprises two mouldings arranged crosswise.

5. Microcomponent according to claim 2, **characterised in that** the top wall (12a) comprises several honeycombed mouldings.

6. Microcomponent according to claim 2, **characterised in that** the top wall (12a) comprises a plurality of blocks arranged in a matrix.

7. Microcomponent according to any of claims 1 to 6, **characterised in that** the cap (12) comprises a lining wall (16) which lines the top wall (12a), the end (14) of the projecting stiffening member (12b) being in contact with the lining wall (16).

8. Microcomponent according to any of claims 1 to 7, **characterised in that** the top wall (12a) and the lining wall (12c), if it is present, comprise at least one orifice ((26.1, 16.2), the orifice (26.2) of the top wall (12a) and the orifice (26.1) of the lining wall (16) communicating with each other.

9. Microcomponent according to claim 8, **characterised in that** the orifice (26.2) of the outermost wall of the cap (13), between the top wall (12a) and the lining wall (16), is flanked by a plug.
